Europäisches Patentamt

European Patent Office

Office européen des brevets

(19)

(11) Numéro de publication: **0 278 870 B1**

(12) **FASCICULE DE BREVET EUROPEEN**

(45) Date de publication de fascicule du brevet: **06.05.92** (51) Int. Cl.⁵: **H05K 13/00**

(21) Numéro de dépôt: **88400308.8**

(22) Date de dépôt: **10.02.88**

(54) **Dispositif pour le poinçonnage en grande série de circuits imprimés.**

(30) Priorité: **11.02.87 FR 8701722**

(43) Date de publication de la demande:
**17.08.88 Bulletin 88/33**

(45) Mention de la délivrance du brevet:
**06.05.92 Bulletin 92/19**

(84) Etats contractants désignés:
**BE CH DE ES GB IT LI**

(56) Documents cités:
**EP-A- 0 075 152**
**FR-A- 2 248 666**
**US-A- 3 125 917**

(73) Titulaire: **Cahne, Françoise**
**50, rue Rambuteau**
**F-75003 Paris(FR)**

(72) Inventeur: **Cahne, Françoise**
**50, rue Rambuteau**
**F-75003 Paris(FR)**

(74) Mandataire: **Plaçais, Jean-Yves et al**
**Cabinet Netter, 40, rue Vignon**
**F-75009 Paris(FR)**

Rank Xerox (UK) Business Services
(3.08/2.19/2.0)

## Description

L'invention concerne le poinçonnage en grande série des plaques de circuits imprimés.

On sait que la préparation d'une plaque de circuit imprimé comprend les opérations ci-après :

- débit d'une plaque cuivrée au format voulu,
- opération de "pilotage" qui consiste à déterminer sur la plaque des repères servant pour les opérations ultérieures,
- impression des pistes sur une face de la plaque,
- gravure des circuits imprimés,
- impression complémentaire (la plupart du temps),
- étamage de la plaque de circuit imprimé,
- réalisation finale des perforations voulues dans la plaque de circuit imprimé, qui comporte des trous de petite taille, typiquement moins de 2 millimètres, des trous de taille plus importante, à quoi s'ajoute la plupart du temps la réalisation d'encoches et du pourtour de la plaque de circuit imprimé.

Les trous de petite taille sont les plus nombreux, dans une plaque de circuit imprimé. Ils sont généralement d'un diamètre de l'ordre du millimètre, et doivent être réalisés avec un pas réduit, typiquement 2,54 millimètres, pouvant descendre jusqu'à 1,78 millimètres dans certains cas.

Il est envisageable de réaliser les trous des circuits imprimés par poinçonnage, l'usage d'une telle opération étant par ailleurs bien connue dans le domaine des métaux. Ceci pose des problèmes, dans le cas des plaques de circuit imprimé, tout d'abord compte tenu de la précision de positionnement requise, explicitée plus haut, et aussi compte tenu de phénomènes de bourrage que l'on rencontre avec le matériau des circuits imprimés.

En effet, comme on l'explicitera plus loin, il s'est avéré que le matériau constitutif des circuits imprimés n'a pas le même comportement que les métaux, lors du poinçonnage : les déchets cylindriques forment une file qui peut s'accrocher sur une paroi, puis par une sorte de prise en masse, en vient à obturer le passage d'évacuation prévu pour ces déchets, d'où un bourrage qui finit par casser le poinçon.

Si, d'un côté, on veut assurer un excellent positionnement des trous, l'homme de l'art songera alors à utiliser des matrices épaisses, car moins sujettes à déformation. Malheureusement, le bourrage se fait alors d'autant plus fréquent.

Le document FR-A-2 248 666 décrit un outil de poinçonnage pour circuits imprimés. L'outil comporte une matrice de faible épaisseur. La matrice est percée des trous qui débouchent dans les trous plus grands d'une semelle en appui sur les bords d'une autre semelle.

La Demanderesse a observé qu'une matrice mince est donc préférable, son épaisseur pouvant aller de 5 à 10 millimètrès environ, et de préférence se situer autour de 6 millimètres. Et il est bon, pour éviter le bourrage, qu'à l'opposé de sa face qui porte le circuit imprimé, les perforations de la matrice soient évasées, par exemple par chanfreinage tronconique selon un angle de 45°. Il est souhaitable aussi que ces perçages de la matrice débouchent sur un large espace, pour éviter l'accrochage de la file de déchets de poinçonnage sur les parois.

Cette solution convient en elle-même pour des circuits imprimés de petite taille. Par contre, pour les circuits imprimés de grande taille, une matrice de 6 millimètres ne peut supporter des efforts très importants de poinçonnage, qui peuvent atteindre environ $10^6$ Newtons.

La présente invention vient résoudre ce problème.

D'une manière générale, l'invention propose un dispositif pour le poinçonnage en grande série de plaques de circuit imprimé qui comporte, en combinaison :

- une matrice mince, propre à porter le circuit imprimé, muni de perforations correspondant à celles désirées dans le circuit imprimé,
- un porte-matrice comprenant au moins une grille de barreaux parallèles, et parallélépipédiques, sensiblement équidistants, reliés à leurs deux extrémités opposées par deux barres perpendiculaires, en particulier logées dans la demi-hauteur des barreaux, et
- des moyens de poinçonnage actionnables au droit de chacune des perforations de la matrice.

Selon un premier mode de réalisation de l'invention, les barreaux de la première grille comportent des évidements inclinés vers l'espace inter-barreaux, du côté de la matrice, là où celle-ci comporte des perforations au droit de ces barreaux; cette première grille de barreaux est à son tour supportée par une seconde grille de barreaux, parallèles et sensiblement équidistants, qui s'étendent perpendiculairement aux premiers, et sont usinés en pointe du côté de la matrice, sauf là où ils supportent les premiers barreaux, leur section droite étant alors rectangulaire. Avantageusement, ces seconds barreaux sont leur tour supportés par une semelle rigide.

Ceci permet, avec un seul poste, de réaliser le poinçonnage de tous les petits trous que comporte la plaque de circuit imprimé.

Selon un autre mode de réalisation de l'invention, on prévoit un second poste, agencé comme le premier, mais dont la matrice est propre à recevoir le circuit imprimé en position conjuguée par rapport aux barreaux de la première grille. Ceci permet de réaliser au niveau du second poste les perforations qui se trouvaient situées au droit des barreaux, dans le premier poste.

L'interconnexion entre les deux postes peut être assurée de la manière qui sera décrite plus loin.

Selon un autre aspect de l'invention, les moyens de poinçonnage comportent des poinçons courts montés sur un porte-poinçon à course réduite, opérant en attelage oscillant.

Avantageusement, la plaque supérieure du réducteur de course est équipée de brides alésées pour l'attelage des outils.

Selon un autre aspect de l'invention, chaque poste est équipé de moyens de transfert permettant d'introduire et d'extraire la plaque de circuit imprimé, en même temps que d'évacuer les déchets de poinçonnage présents sous la matrice. L'évacuation des déchets peut se faire par exemple par raclage.

Selon un autre aspect de l'invention, l'épaisseur de la matrice est de 5 à 10 millimètres, de préférence environ 6 millimètres.

Selon encore un autre aspect de l'invention, le dispositif comporte un autre outil de poinçonnage pour la réalisation du contour de la plaque, des trous de forme de celle-ci, et de ses trous de diamètre important, en particulier de diamètre supérieur à environ 2 millimètres.

Enfin, il est intéressant que les différents outils, auxquels on donne les mêmes dimensions, soient disposés côte à côte, et desservis par des moyens de transfert communs actionnés par exemple par vérins pneumatiques.

Les outils sont avantageusement groupés sur une seule presse d'actionnement, de manière à réaliser le poinçonnage en une seule opération.

L'alimentation générale du dispositif peut se faire à partir d'un premier poste, ou poste de charge, propre à délivrer les plaques de circuit une à une, à partir d'une pile.

D'autres caractéristiques et avantages de l'invention apparaîtront à l'examen de la description détaillée ci-après, et des dessins annexés sur lesquels :

- la figure 1 illustre en élévation un premier type de machine de poinçonnage connu, dit type "fermé";
- la figure 2 illustre un second type de machine de poinçonnage, dit type "ouvert";
- les figures 3 et 4 sont deux schémas montrant des difficultés rencontrées dans le poinçonnage de circuits imprimés;
- la figure 5 est, à titre d'exemple, une vue de dessus d'une plaque de circuit imprimé double, montrant différentes perforations à réaliser dans celle-ci;

- les figures 6A, 6B et 6C, qui se correspondent, montrent un premier mode de réalisation de l'invention;
- les figures 7A, 7B, 7C et 7D, qui se correspondent, montrent un second mode de réalisation de l'invention;
- les figures 8A, 8B et 8C montrent un exemple de poste utilisable pour la mise en oeuvre de l'invention;
- les figures 9A, 9B et 9C montrent un poste de charge utilisable pour l'alimentation des postes de travail selon l'invention;
- la figure 10 est une vue schématique de dessus d'un poste de desserte de différents postes utilisés selon l'invention;
- les figures 11a et 11B illustrent certains détails du poste de transfert selon l'invention, et
- les figures 12A et 12B sont des schémas d'automatismes.

L'invention fait intervenir des caractéristiques géométriques à de nombreux titres. Par ailleurs, les dessins annexés comportent de nombreux éléments de caractère certain. En conséquence, ces dessins sont incorporés à la description pour mieux faire comprendre celle-ci.

Les machines dites de poinçonnage sont généralement utilisées dans le travail des métaux. On connaît ainsi la presse dite KB243, décrite par exemple dans l'ouvrage commercialisée par COFMO 18, rue Philippe Lalouette - 43700 DRANCY.

La présente invention concerne la perforation des circuits imprimés par poinçonnage, réservée aux fabrications de très grande série, à l'exclusion des techniques de perçage utilisables également.

Pour réaliser par poinçonnage les trous des circuits imprimés, il faut utiliser un poinçon et une matrice correspondante, dont la forme est habituellement ronde, mais peut être différente.

Les outils de poinçonnage classiques peuvent être répartis en deux catégories, à savoir celle des outils fermés et des outils ouverts.

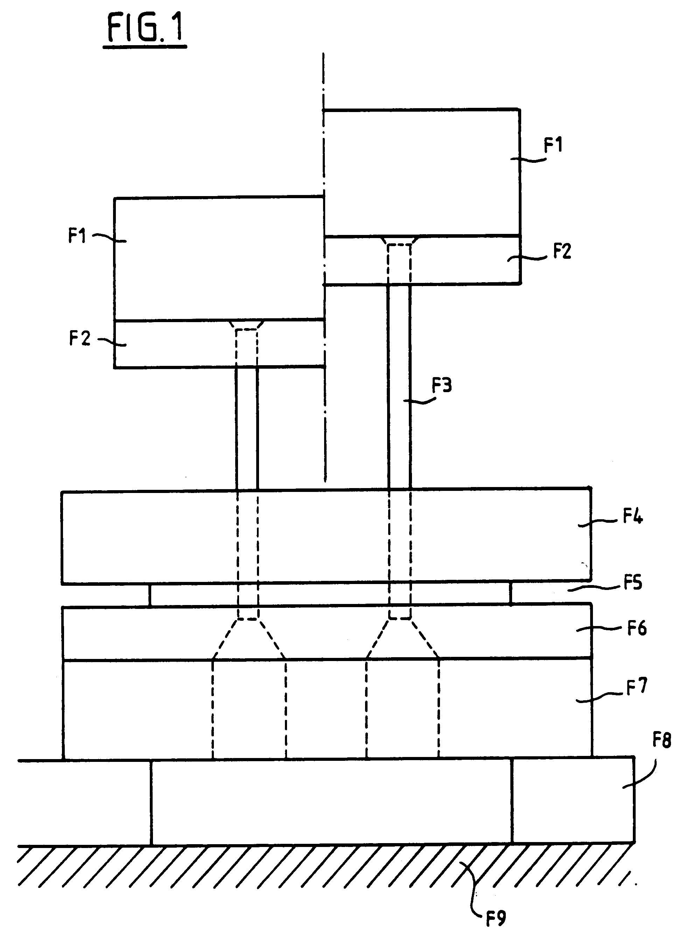

L'outil fermé (figure 1) est composé de plusieurs plaques, à savoir :

- une plaque de choc F1 qui est attelée au coulisseau de la presse,
- une plaque porte-poinçon F2, fixée sur la plaque de choc F1, et qui constitue avec les poinçons F3 l'ensemble mobile;
- une plaque guide et dévêtisseuse F4 (l'expression "dévêtisseuse" indique que cette plaque devra séparer le poinçon de la pièce qu'il aura emportée);
- des plaques formant entretoises et guides latéraux F5;
- la matrice proprement dite F6;
- un porte-matrice F7;
- des tasseaux de surélévation F8; et enfin
- une table de presse F9.

La partie mobile est représentée pour moitié en position de repos (à droite) et pour moitié en position de travail (à gauche).

Cet outil est dit "fermé". On appelle outil fermé, un outil dans lequel la matrice et le guide-poinçon qui sert de dévêtisseur, sont solidaires. De cette manière, pour les pièces peu épaisses, il présente une sécurité d'emploi, car on ne peut y introduire un doigt.

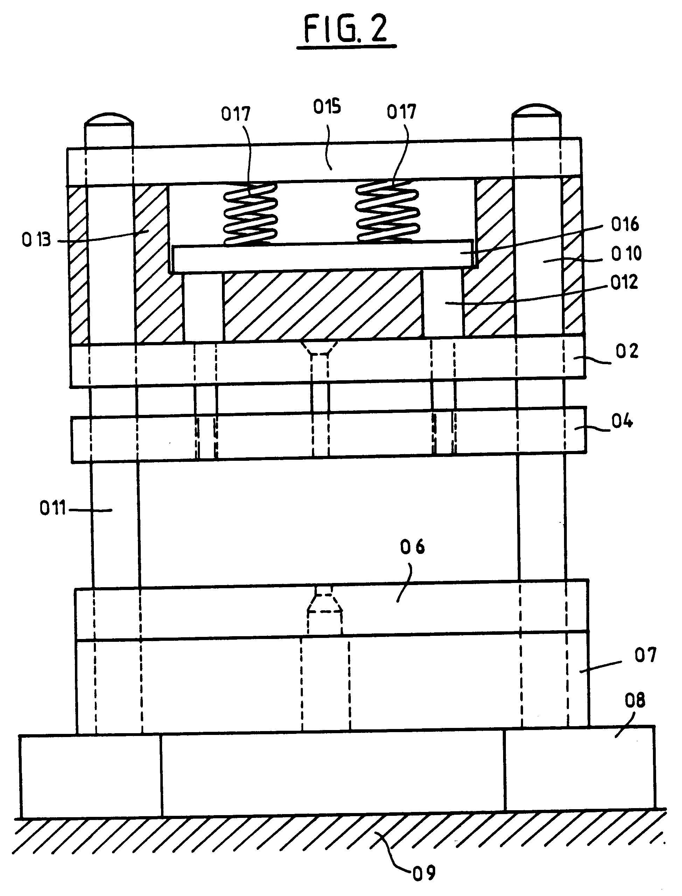

La figure 2 fait apparaître un outil ouvert. Cet outil est composé d'un nombre supérieur de plaques. Ces parties analogues à l'outil fermé portent la même référence numérique, précédée du préfixe O au lieu de F.

On remarque en outre que l'outil ouvert, ou à presse plan de la figure 2 possède deux colonnes de guidage 010 et 011.

Il s'y ajoute :
- des entretoises poussoirs 012,
- une plaque cuvette 013 munie de ressorts de compression 017,
- une plaque de choc 015,
- une plaque de transfert de poussée 016,
- et des ressorts de compression 017 ménagés entre la plaque de choc 015 et la plaque de transfert de poussée 016.

L'ensemble mobile est actionné par la presse, qui peut être le modèle KB243 déjà cité. Le plateau 04 arrive en contact avec la pièce à découper et, le mouvement descendant continuant, le second plateau 02 vient contre le plateau 04, tandis que le poinçon pénètre dans la pièce, qui se trouve alors comprimée entre le plateau 04 et la matrice 06.

En remontant, les ressorts 017, qui se sont trouvés comprimés par le mouvement de descente, poussent sur la plaque 04, ce qui a pour effet de dévêtir les poinçons.

Avec un outil de ce type, il y a lieu d'utiliser une presse plus puissante qu'avec un outil fermé selon la figure 1. Il faut ajouter à l'effort de poinçonnage, l'effort de dévêtissage qui peut être de l'ordre de 30% de l'effort de poinçonnage.

Jusqu'à présent, les circuits imprimés complexes sont fabriqués soit à l'aide de plusieurs presses, soit sur une seule presse, plus importante, mais avec des outils ouverts, pour permettre l'amenage.

La présente invention vient permettre l'usage d'outils fermés.
La particularité des circuits imprimés réside surtout dans le fait que l'on a une grande quantité de petits trous d'un diamètre voisin de 1 millimètre, typiquement 0,8 à 1,5 millimètres, et que l'on doit réaliser ces petits trous avec un pas descendant jusqu'à des valeurs assez faibles, typiquement 2,56 millimètres, plus rarement 1,78 millimètres.

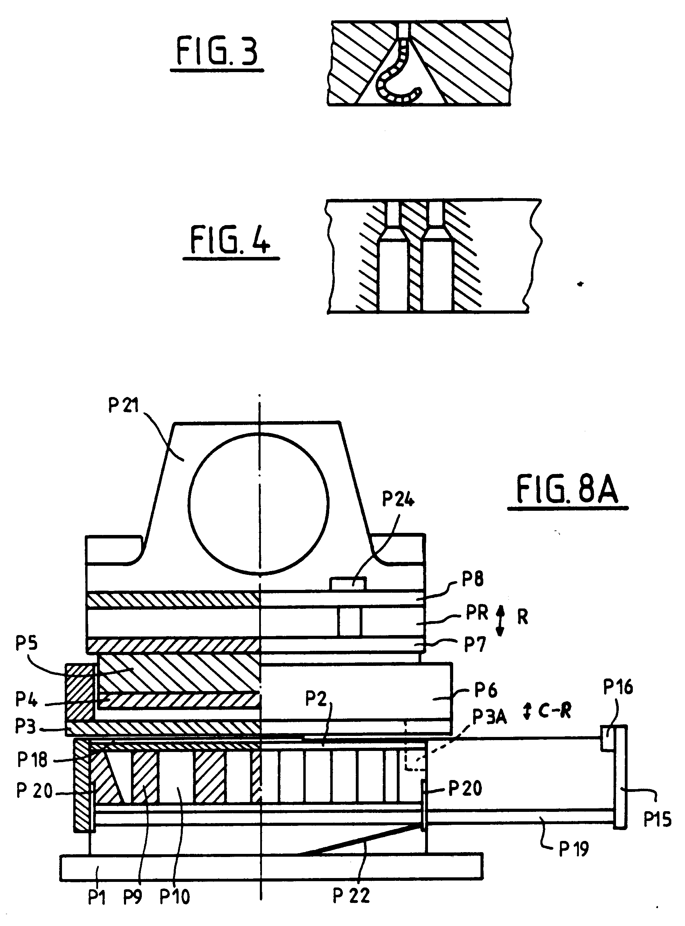

Les déchets de poinçonnage, c'est-à-dire les pastilles résultant de la découpe, ont tendance à coller les unes aux autres et à former des cordons qui s'enroulent sur eux-mêmes, comme illustré sur la figure 3. Leur évacuation n'est possible que si le dégagement de la matrice est très large.

Dans le cas de trous rapprochés, dont l'entr'axe est de 2,54 millimètres, il n'est possible d'effectuer qu'un dégagement de 2 millimètres maximum, comme le montre la figure 4. Et, si même ce dégagement est trop long, la matrice étant épaisse, le cordon de pastille s'accroche aux parois et arrive quand même à obstruer complètement la cavité, ce qui entraîne la casse du poinçon.

L'expérience a montré qu'une matrice de 10 millimètres peut être usinée, mais à condition de bien polir les parois de dégagement, et si possible de leur donner une légère conicité. Cette solution, qui peut donner satisfaction dans certains cas, souffre néanmoins de son caractère excessivement onéreux.

Par contre, avec des matrices d'épaisseur 6 millimètres, un usinage normal de la matrice est suffisant, et on arrive par conséquent à une solution plus économique.

Par contre, avec des matrices de 6 millimètres, il a été remarqué qu'il faut, lorsque la dimension des circuits est importante, prévoir un "porte-matrice" pour permettre de résister aux efforts de poinçonnage, qui sont environ de 60 kilos pour un trou de 1 millimètre de diamètre.

La difficulté réside dans l'usinage de ce porte-matrice.

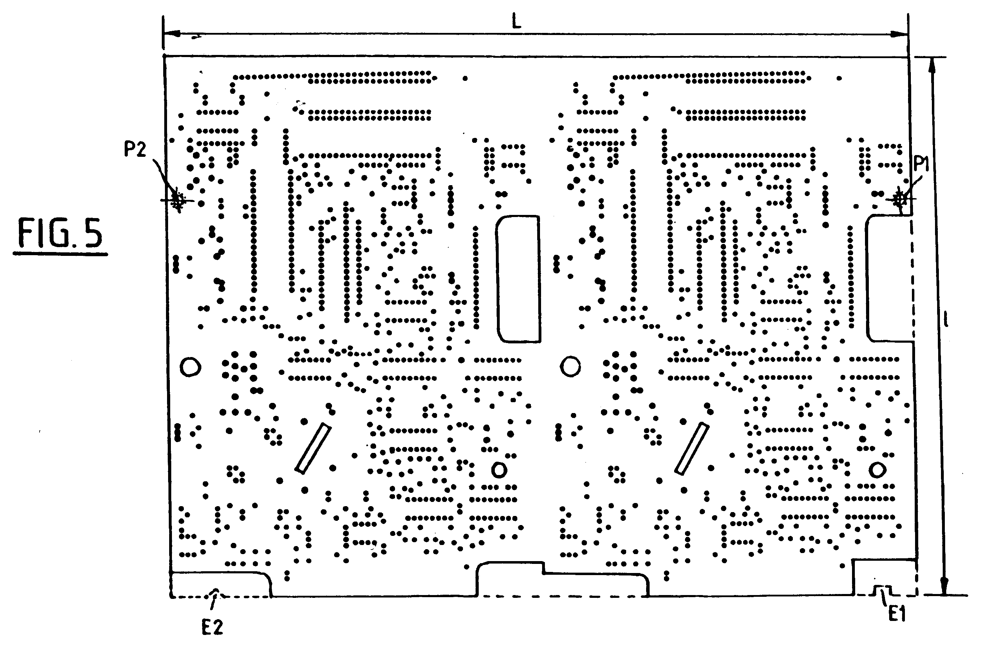

La préparation des circuits imprimés selon l'invention va comporter les étapes suivantes :
- débit d'une plaque cuivrée dans le format du circuit;
- opération mécanique de pilotage, exécutée avec un outil fermé tel que décrit sur la figure 1, et comportant la réalisation de deux trous qui serviront au recentrage de la plaque dans les outillages successifs, ces trous apparaissant en P1 et P2 sur la figure 5, ainsi que de deux encoches de positionnement, visibles en E1 et E2 également sur la figure 5;
- impression des pistes;
- gravure des pistes;
- impression complémentaire;
- étamage;
- poinçonnage final.

Les outils proposés selon l'invention permettent, aussi bien dans l'opération de pilotage que dans le poinçonnage final, de réaliser les travaux d'une manière semi-automatique ou même totalement automatique.

Les outils proposés selon l'invention pour le pilotage et le poinçonnage sont du type outils fermés, comme décrit sur la figure 1.

Ils présentent cependant la particularité que les guides latéraux visibles en F5 sont ramenés à peu près aux deux tiers environ de la largeur du circuit imprimé à fabriquer.

Les outils de poinçonnage ont exactement les mêmes dimensions. Ils sont tous équipés d'un système de translation permettant l'introduction et l'extraction de la plaque de circuit imprimé de l'outil, et en même temps le balayage des déchets de poinçonnage.

Comme on le verra plus loin, les outils de poinçonnage final peuvent être accouplés, et l'ensemble pourvu d'un poste de charge.

La figure 5, déjà mentionnée, montre à titre d'exemple une plaque de circuit imprimé à perforer avec une multitude de petits trous, des trous d'épaisseur plus importante, les perforations P1, P2, déjà mentionnées, de même que les encoches E1, E2, ainsi que d'autres évidements à effectuer ultérieurement, à l'intérieur de la plaque et sur le contour de celle-ci.

L'examen attentif montre qu'après séparation en deux parties, la plaque fournit deux circuits imprimés identiques.

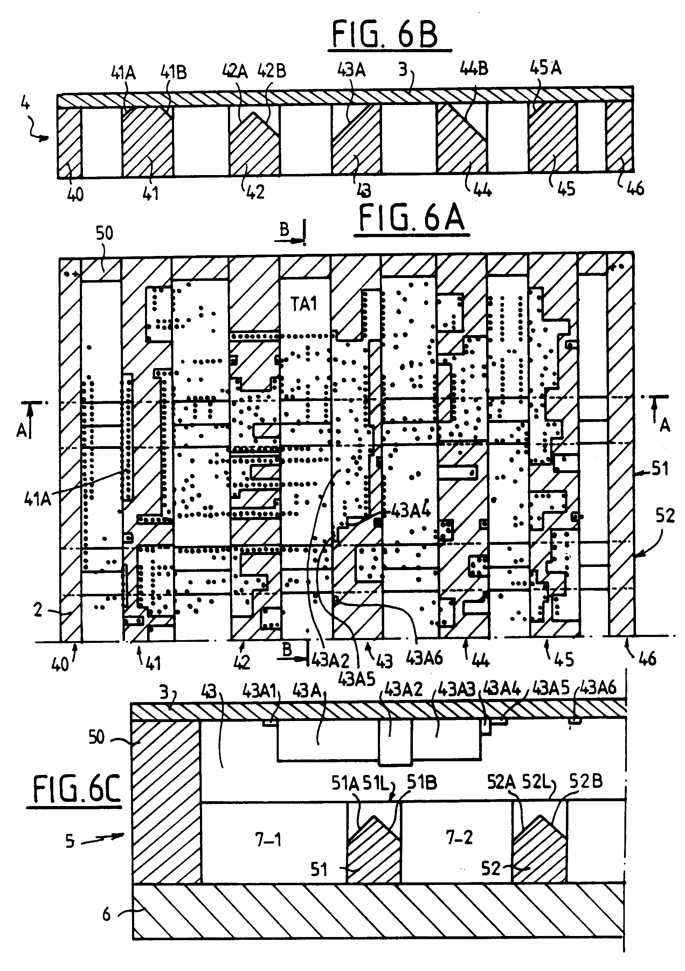

Les figures 6A, 6B et 6C montrent une première manière de mettre en oeuvre l'invention. Pour simplifier le dessin, on s'est limité à une moitié du circuit imprimé de la figure 5, dont on retrouvera les éléments sur la figure 6A. Ce circuit imprimé, noté 2 dans son ensemble, est supporté par une matrice 3 dont les perforations n'ont pas été représentées pour simplifier. La matrice 3 est à son tour supportée par deux tasseaux d'extrémité 40 et 46, ainsi que par des tasseaux intermédiaires 41 et 45. Les zones en grisé, sur les dessins, indiquent les zones d'appui de la matrice.

Ces zones en grisé s'étendent sur toute la largeur du circuit imprimé. Elles sont d'égale largeur et sensiblement équidistantes, et choisies de telle manière que la densité de trous à réaliser y soit minimum, par rapport aux zones adjacentes non grisées. Mais, dans la plupart des cas, il restera des perforations à effectuer au niveau des zones en grisé, et par conséquent au niveau des tasseaux 41 à 45.

Pour permettre tout de même le poinçonnage des orifices qui peuvent ainsi se trouver au droit des barreaux 41 à 45, ceux-ci présentent localement des chanfreins inclinés vers l'espace inter-barreaux, comme illustré par exemple en 41A, 41B, 42A, 42B, 43A, 44B et 45A. Cette illustration de la figure 6B correspond à la distribution des trous qui se trouvent au niveau de la ligne de coupe A-A de la figure 6A. Pour simplifier, les traits délimitant les fraisages de ces chanfreins n'ont pas été représentés.

On observe pratiquement en 41A sur la figure 6A une double rangée de trous qui recouvrent le bord gauche du barreau 41. Le poinçonnage de ces trous demeurera possible, ainsi que l'évacuation des déchets, qui seront renvoyés par le plan incliné 41A (en pratique à 45° vers un espace profond entre les barreaux 40 et 41 dans le cas présent). La même observation vaut pour le chanfrein 41B, de l'autre côté du barreau 41.

Le barreau 42 montre un cas où les chanfreins 42A, 42B se rejoignent pour former une pointe, c'est-à-dire que, localement, le barreau 42 ne va pas supporter la matrice 3. Cependant, la figure 6A montre que cette condition n'existe que sur une courte longueur du barreau 42 qui, par contre, va pouvoir supporter la matrice en d'autres endroits, d'une façon suffisante pour lui permettre de résister aux très importants efforts de poinçonnage.

Des chanfreins plus importants, mais unilatéraux, sont illustrés en 43A et 44B. On notera qu'il est préféré un seul chanfrein dans ces deux cas, plutôt que deux. En effet, l'application au barreau 43 de la solution à deux chanfreins au niveau de la ligne de coupe A-A conduirait à une longue distance du barreau 43 sur laquelle la matrice 3 ne serait pas supportée.

Plus généralement, l'examen global de la figure 6 montre que la configuration d'appui de la matrice 3 sur les barreaux 41 à 45 peut revêtir des formes très variées. L'essentiel est de faire en sorte que cette matrice demeure convenablement supportée sur toute sa surface.

Sur la figure 6C, il apparaît que les barreaux du premier jeu ou de la première grille, tels que 43, sont tenus en bout par des barreaux dans l'autre sens, tels que 50. De façon sous-jacente, ils sont supportés par d'autres barreaux 51 et 52 qui possèdent une forme prismatique avec un côté pointu vers le haut. Ce côté pointu est défini par exemple par l'intersection de deux côtés égaux 51A et 51B, inclinés à 45° sur l'horizontale (de la figure 5). Bien entendu, au droit des barreaux tels que 43, le barreau 51 possède une section droite rectangulaire, pour permettre le soutien de ce barreau. Enfin, les barreaux 51 et 52 du second jeu sont supportés par une semelle rigide 6 qui complète le porte-matrice.

On obtient ainsi une structure extrêmement rigide qui permet le soutien convenable du circuit imprimé, sur toute la surface de la matrice 3, tout en laissant un espace extrêmement large pour le passage des déchets, et en présentant des plans inclinés partout où cela est nécessaire pour permettre le renvoi de ces déchets vers les zones d'évacuation.

Sont alors finalement disponibles des couloirs tels que 7-1 et 7-2 dans lesquels on retrouvera finalement la quasi-totalité des déchets, qui peuvent alors être évacués, de préférence par des moyens de raclage, non représentés, propres à balayer sur commande chacun des couloirs 7-1, 7-2, etc.

L'exemple particulier du barreau 43 illustré sur la figure 6C montre la distribution dans l'autre sens des chanfreins portés sur ce barreau.

Le chanfrein 43A1 est prévu pour permettre l'évacuation du déchet d'un trou unique TA1, se trouvant au niveau du barreau 43. Un large chanfrein 43A vient accomoder une zone assez riche en trous à poinçonner. Cette zone devient encore plus large en 43A2, pour tenir compte de deux trous supplémentaires situés un peu plus à droite, sur la figure 6A, au droit du barreau 43. On retrouve ensuite une zone 43A3 semblable à la zone 43A. Enfin, des zones 43A4, 43A5 et 43A6 viennent prendre en charge d'autres trous, situés à moins grande distance du barreau 43 sur la figure 6A.

Bien entendu, l'invention peut être réalisée de différentes manières. Dans l'exemple décrit ci-dessus, les grilles de barreaux sont formées en pratique de tasseaux usinés, réunis à leurs extrémités par des entretoises. Une variante simple consisterait à prévoir que chaque grille est formée directement par usinage d'un seul bloc de matière, à la forme voulue.

Par ailleurs, il peut être intéressant que les barreaux ou tasseaux de bord de la première grille (au moins) soient chanfreinés, selon leur position par rapport au tracé du circuit imprimé.

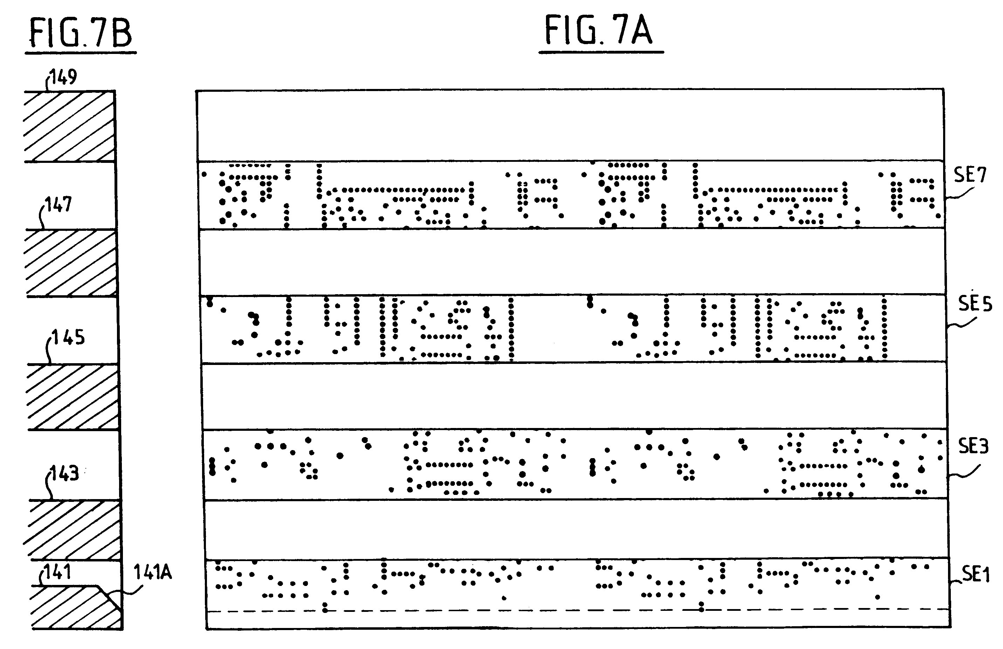

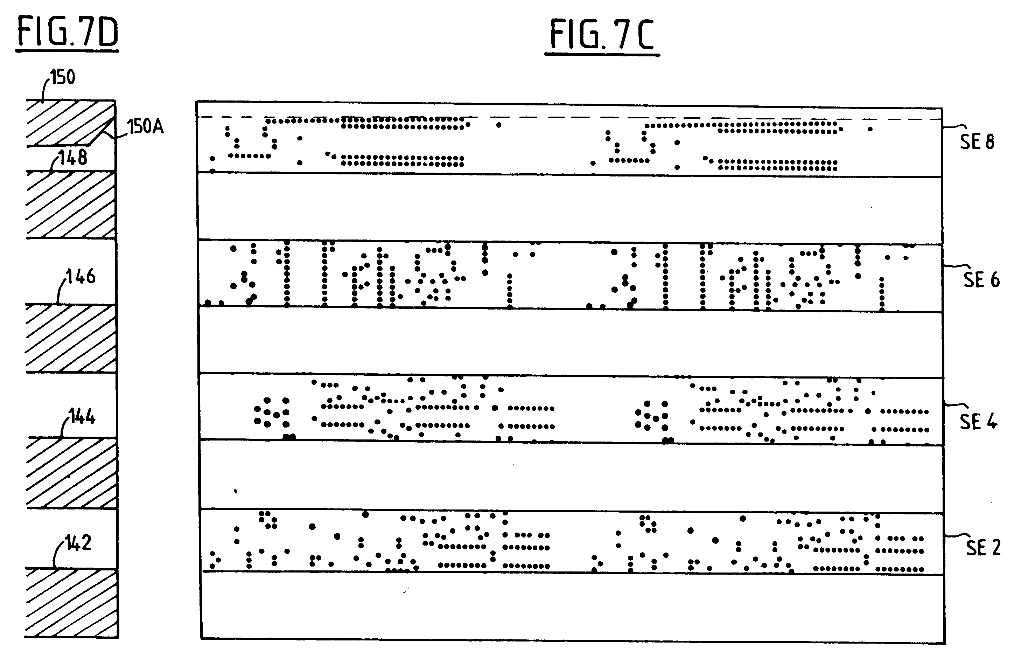

L'homme de l'art comprendra cependant qu'un circuit imprimé tel que celui de la figure 5 ne peut pas toujours être réalisé en une seule fois, c'est-à-dire avec un seul outil, dont les barreaux du porte-matrice soient usinés comme il vient d'être décrit. C'est pourquoi on préférera, souvent, utiliser deux outils successifs pour faire cet usinage. Les choses se passent alors de la manière que l'on décrira maintenant en référence aux figures 7A à 7C. Un premier outil va réaliser les perforations situées au niveau de segments SE1, SE3, SE5 et SE7 du circuit imprimé. Ces segments sont en principe de même largeur et équidistants, tout en étant disposés de manière asymétrique par rapport à la direction principale du circuit imprimé considéré.

On observera toutefois que le premier segment SE1 est réduit, pour des raisons que l'on considérera ci-après.

Pour cette première opération, le soutien du porte-matrice donc dans le premier outil du premier poste est assuré par des tasseaux 141, 143, 145, 147 et 149, placés entre les verticales des segments SE à perforer. On observe que le maintien latéral du côté bas de la plaque de circuit imprimé est assuré par un évidement 141A du tasseau 141.

L'usinage complémentaire est assuré au niveau d'un second poste, où l'on aura à traiter les zones SE2, SE4, SE6 et SE8 du circuit imprimé (figure 7C). Les tasseaux 142, 144, 146, 148 et 150 sont alors placés entre les segments SE2, SE4, SE6, SE8, c'est-à-dire en fait au niveau des anciennes zones usinées SE1, SE3, SE5 et SE7, sauf bien entendu pour le dernier tasseau 150, qui possède un évidement 150A, pour la même raison que le tasseau 141 de la figure 7A.

On notera au passage que l'usage d'un tasseau évidé sur le bord n'est en général pas gênant, car la densité de perforations d'un circuit imprimé est le plus souvent assez faible au voisinage de son bord.

Le reste de la présente description est donné dans l'hypothèse où le circuit imprimé de la figure 5 est réalisé de la manière qui vient d'être décrite, c'est-à-dire en deux passes, faisant intervenir deux postes successifs.

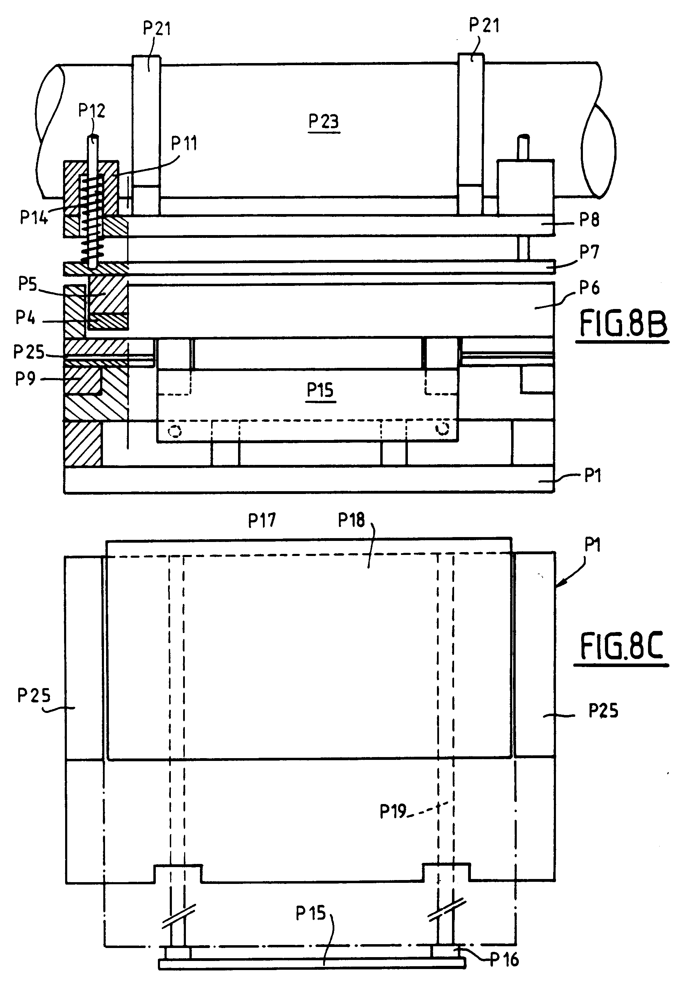

Chacun de ces postes possède la structure apparaissant sur les figures 8A, 8B, 8C. Sur ces figures, l'outil de poinçonnage comprend tout d'abord une plaque de base P1, au-dessus de laquelle on voit la matrice mince P2, supportée par un réseau de barreaux P9.

On aura bien entendu deux outils de ce genre, dont les traverses ou barreaux P9 et les matrices P2 sont respectivement obtenus comme illustré sur les figures 7A et 7C.

Un troisième outil, construit de manière légèrement différente, réalisera le détourage, c'est-à-dire les trous de plus grand diamètre, les évidements et autres aménagements de contour de la plaque de circuit imprimé.

On revient maintenant à la figure 8A, où il apparaît un guide P3 renforcé par un cadre P6 dont il est solidaire. On observe en P4 le porte-poinçon, les poinçons eux-mêmes n'étant pas figurés. Par ailleurs, en P3A est prévu un logement pour recevoir le plot de positionnement P16.

La plaque de choc se trouve en P5. Sur la plaque de choc P5 est fixé un ensemble réducteur de course formé par deux plaques P7 et P8. Le réducteur de course est noté PR dans son ensemble. Aux quatre angles de cette plaque P8 se trouvent fixées quatre cloches convenablement alésées pour laisser passer les ressorts P14 et les colonnettes P12.

Ces colonnettes P12 sont fixées dans la plaque P7 et servent à guider les ressorts P14, ainsi que les deux plaques P7 et P8 l'une par rapport à l'autre.

Les quatre ressorts P14 maintiennent l'écartement R entre les plaques P7 et P8, en coopération avec les quatre vis épaulées P24, qui sont au nombre de deux de chaque côté de la plaque.

La plaque P8 est attelée par l'intermédiaire des plaques alésées P21 à l'axe P23.

Cet axe P23 est fixé d'une manière rigide au coulisseau de la presse, en laissant un espace de 2 à 3 millimètres pour permettre aux plaques d'attelage P21 d'osciller librement autour de cet axe. Par ailleurs, cet axe P23 est de section appropriée à l'effort à transmettre et de longueur adaptée au nombre d'outils à monter.

Par ailleurs, l'axe P23 est largement dimensionné pour supporter l'effort de poinçonnage des trois outils, qui vont donc être attelés ensemble sur la même presse, et sa longueur est naturellement égale à la longueur totale des trois outils.

Il convient maintenant d'expliciter le rôle du réducteur de course.

On sait que pour une presse à excentrique, qui est le cas de la grande majorité des machines utilisées, il faut, pour bénéficier de la puissance maximum de la machine, régler la course du coulisseau à une valeur minimum en fonction de l'épaisseur à découper.

Par exemple, pour une épaisseur de plaque de 1,5 millimètre, cette course serait de l'ordre de 25 millimètres.

Une telle course obligerait à avoir une plaque guide très épaisse (30 millimètres), ce qui, pour des perçages de diamètres de 1 à 2 millimètres est très onéreux, étant observé par ailleurs que la longueur des poinçons requis les rend fragiles.

L'usage selon l'invention d'un réducteur de course élimine cet inconvénient.

Le fonctionnement général du dispositif des figures 8 est le suivant : dans le mouvement de descente, l'ensemble suit jusqu'au moment où les poinçons rencontrent la pièce, c'est-à-dire la plaque de circuit imprimé à poinçonner. L'effort de poinçonnage étant élevé, la plaque P7 est arrêtée, et la plaque P8 continue à descendre en comprimant les ressorts 14, jusqu'au contact de la plaque 7 qui reçoit alors la puissance totale de la presse.

En remontant, les ressorts P14 écartent les plaques P7 et P8. La plaque P8, par l'intermédiaire des boulons P24, entraîne l'ensemble du porte-poinçon.

La course du porte-poinçon se trouve réduite, et ramenée à la valeur C-R, où C est la course de la presse et R la distance entre les plateaux P7 et P8.

On examinera maintenant un dispositif de translation dont est équipé l'outil, et qui permet d'introduire la plaque de circuit imprimé dans l'outil et de la retirer. Ce dispositif est composé d'une plaque avant P15, et d'une plaque arrière P17. Ces deux plaques sont reliées par deux axes P19, guidées par quatre plaques palières P20. Sur la plaque P15 sont fixés des plots P16.

Sur la plaque P17 est fixée une plaque P18 dont l'épaisseur est légèrement inférieure à l'espace entre la matrice et le guide.

On sait que le positionnement exact d'un circuit imprimé dans l'outil est assuré par des "trous pilotes". On admettra que ceux-ci peuvent "rattraper" environ 0,8 mm dans les deux dimensions.

Sur la figure 8C, on voit qu'entre la plaque P18, et les poussoirs P16, il reste un espace égal à la largeur 1 du circuit imprimé, augmentée de 0,8 mm. De même, dans l'autre sens, l'espacement des guides P25 est la longueur L du circuit imprimé, plus 0,8 mm.

Enfin, des plaques inclinées P22, solidaires des axes 19, servent à évacuer les déchets de poinçonnage.

Avant d'aborder la structure d'ensemble de la machine, on considérera tout d'abord le poste de charge, c'est-à-dire celui destiné à alimenter l'installation en plaques de circuit imprimé à poinçonner (ou à "piloter", le cas échéant).

Un tel poste de charge se compose d'une plaque de base Q1, supportant une plaque Q2, située au même niveau que la matrice.

Sur la plaque Q2, un empilage de plaques de circuit imprimé Q15 est positionné par six colonnes Q13, et vient en butée vers l'avant sur une plaque Q14.

Cette plaque Q14 présente une lumière Q15A, en partie basse, la hauteur de cette lumière étant supérieure à l'épaisseur d'un circuit imprimé d'environ 0,5 millimètre, de manière à ne laisser passer qu'une plaque de circuit imprimé à la fois.

Deux doigts de poussée Q3 coulissent sur deux axes Q9, reliés par deux plaques Q5 et Q6 dont la hauteur est réglable par rapport à l'empilage.

La plaque Q2 est pourvue de deux lumières Q16 pour laisser passer les doigts Q3.

La hauteur des doigts est réglée de manière à dépasser la face supérieure de la plaque Q2 d'une valeur égale à l'épaisseur d'une plaque de circuit moins environ 0,2 à 0,3 millimètre.

Ce réglage est réalisé par quatre vis Q10 et Q11, montées en opposition.

Les doigts de poussée Q3 comportent chacun un roulement à bille Q17, qui dépasse le sommet des doigts d'environ un millimètre. Les doigts de poussée Q3 sont reliés par une barre Q7 qui est entraînée par l'axe Q8.

Ceci permet de maintenir la pile au-dessus de la plaque en mouvement, et de libérer celle-ci en fin de course pour permettre l'entraînement par les barres Q18 du cadre de transfert Q19, sur lequel on reviendra plus loin.

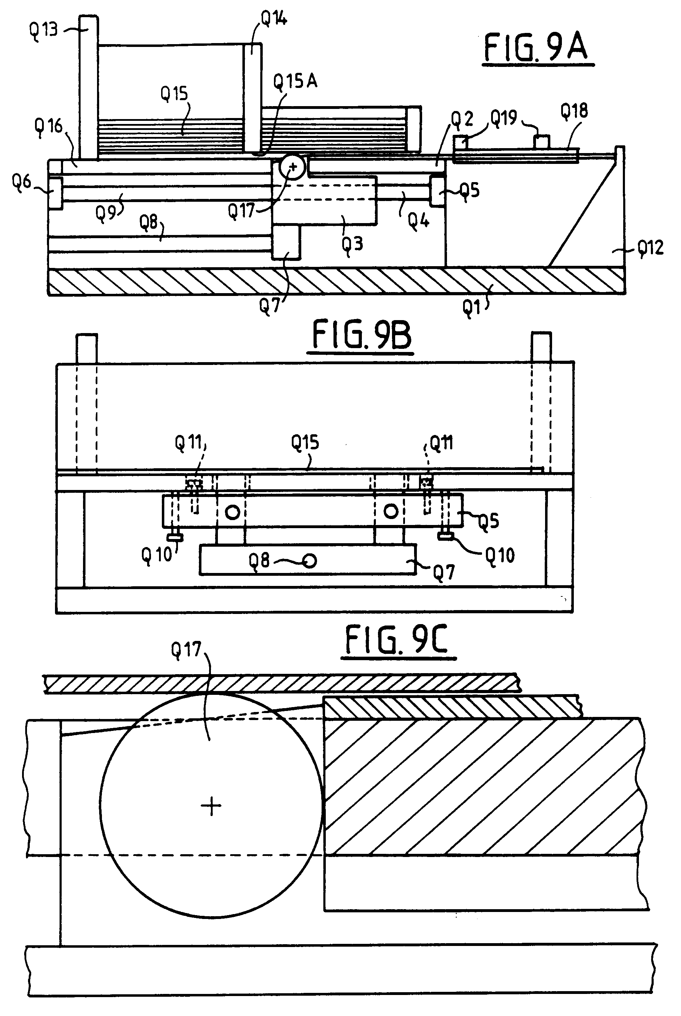

Ces roulements à billes apparaissent en vue agrandie sur la figure 9C.

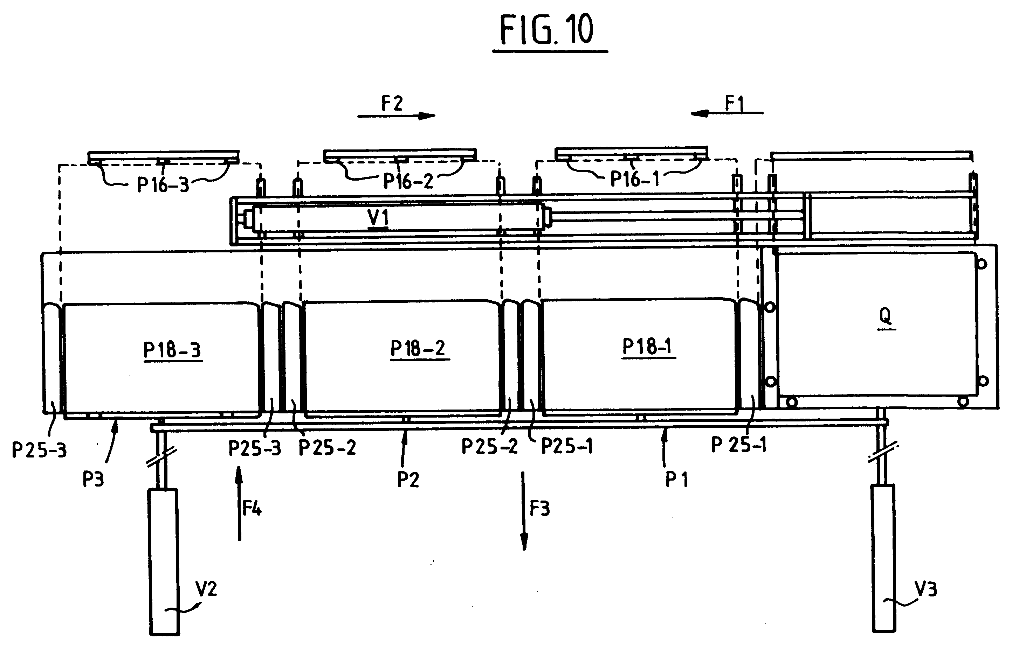

On pourra maintenant mieux comprendre la figure 10, qui illustre la structure générale d'une installation selon l'invention, telle qu'affectée au poinçonnage des trous (celle du pilotage sera naturellement plus simple).

Le poste de charge apparaît en Q sur la figure 10.

Il est suivi de deux postes P1 et P2 destinés respectivement au poiçonnage des petits trous, comme illustré sur les figures 7A et 7C (dans le cas du circuit imprimé donné à titre d'exemple sur la figure 5). Enfin, un dernier poste P3 va réaliser les trous des diamètres supérieurs à 2 millimètres, ainsi que les trous de forme et les trous ou encoches de contour de la plaque de circuit imprimé, opération classiquement appelée "détourage".

La disposition respective du poste de charge et des trois postes de poinçonnage P1 à P3 doit être telle que les circuits, dans leurs positions respectives, se trouvent équidistants.

Les circuits se trouvent alors sur le même plan, puisque les outils sont de dimensions identiques.

Au-dessus du plan des circuits se trouve installé un vérin à double tige V1. Sa course est réglée à une valeur identique au pas de positionnement des outils, dans les différents postes Q, P1, P2, P3. Dans les postes de poinçonnage P1 à P3, on reconnaît les plaques P18-1 à P18-3, et les guides latéraux P25-1 à P25-3.

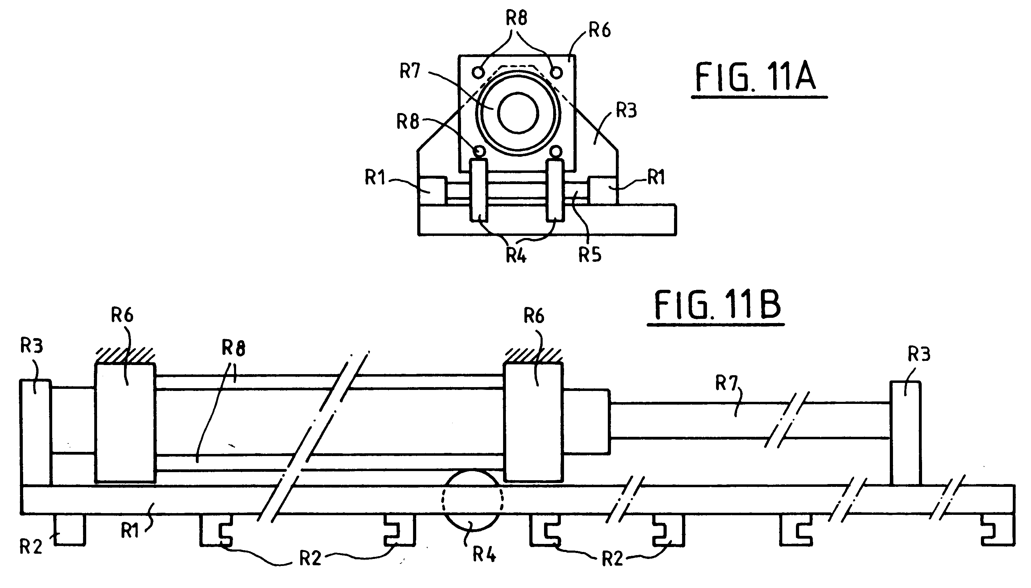

La figure 11 illustre de façon plus précise la plaque ou cadre de transfert avec son vérin de déplacement V1. On note en R1 des barres longitudinales, associées en R2 à des barrettes transversales, dont les sections peuvent varier.

Les barres R1 et barrettes R2 sont désignées par Q18 et Q19 sur la figure 9A.

Les barrettes R2 sont rainurées face à face. L'espace entre fonds de rainure est L + 0,8 mm.

En R3 apparaissent des plaquettes d'assemblage permettant de supporter le vérin et sa tige. En R4 apparaissent des roulements à billes pour le soutien du vérin. Les axes de ces roulements R4 apparaissent en R5.

Les flasques de fixation du vérin sur le bâti apparaissent en R6, tandis que son axe apparaît en R7, et que l'on voit en R8 les tiges d'assemblage du vérin.

Le cadre de transfert est défini par les pièces R1 et R2.

On revient maintenant à la figure 10. Les vérins V2 et V3 permettent l'introduction conjointe des circuits imprimés dans les outils, à l'aide des poussoirs P16, et inversement leur extraction à l'aide des plaques P18.

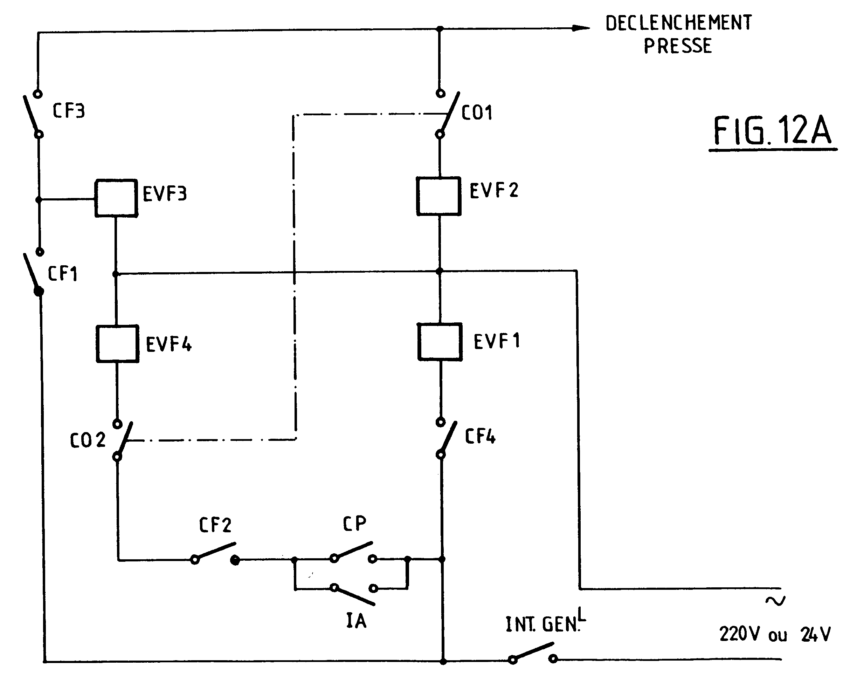

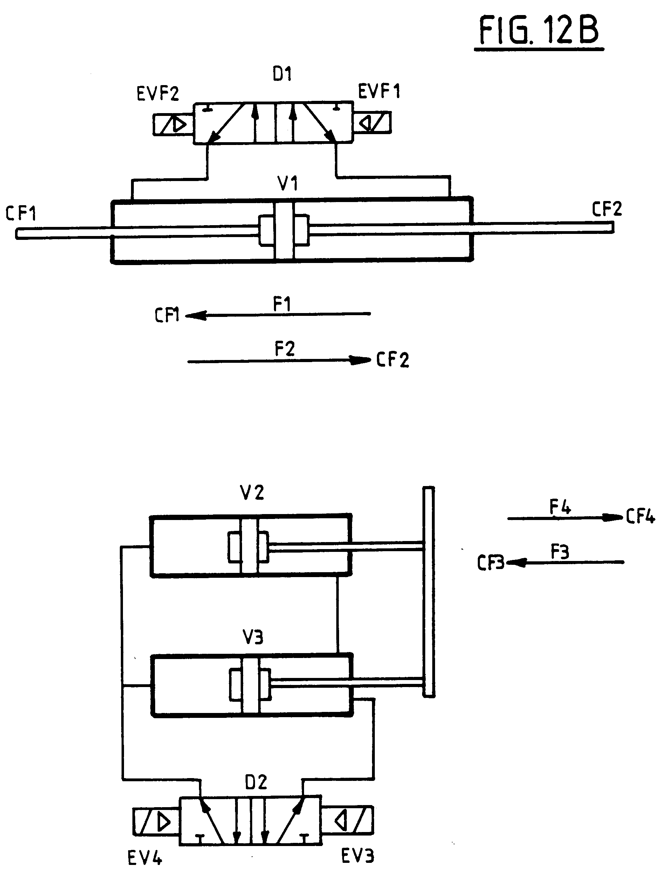

L'automatisme d'une installation telle qu'illustrée par la figure 10, peut être réalisé (figure 12A) au moyen de 4 contacteurs : CF1 - CF2 - CF3 - CF4 actionnés respectivement en fin de course F1, F2, F3, F4 et par un contacteur inverseur CO1/CO2 fixé sur l'un des outils et actionné par celui-ci (CO1 est ouvert quand l'outil est ouvert et fermé pendant le cycle de poinçonnage, CO2 inversement). L'ensemble est complété par un contacteur à poussoir CP en parallèle, sur un interrupteur IA avant de rejoindre le réseau. Le circuit commande les électrovannes EVF1 à EVF4, associés aux distributeurs D1 et D2 (figure 12B).

Le fonctionnement est le suivant :

1° - semi-automatique

    IA ouvert
    CP ouvert

Le cadre de transfert est à droite, avec CF2 fermé. Les vérins V2 V3 sont en position introduction, butée dans le sens de la flèche $F_3$, donc avec CF3 fermé.

En appuyant sur le poussoir CP, ayant préalablement mis un ou plusieurs circuits à poinçonner dans le chargeur, les vérins V2 V3 sont actionnés dans le sens F4, donc une plaque est amenée sur le cadre de transfert.

En fin de mouvement dans le sens, le contact CF4 est fermé et le mouvement F1 est déclenché (électrovanne EVF1). Ceci amène la plaque devant l'outil P1, et ferme le contact F1 qui alimente EVF3 et déclenche le mouvement F3 (introduction). En fin de mouvement, CF3 se ferme et déclenche le poinçonnage. CO1 se ferme et EVF2 est alimenté déclenchant le mouvement F2. Le cadre de transfert revient à droite. Arrivé en butée, il ferme CF2 et dès que l'outil est ouvert, le contact CO2 est fermé et le mouvement s'arrête car CP est relâché, donc ouvert.

2. Cycle automatique :

On ferme l'interrupteur IA et le cycle recommence et se poursuit indéfiniment. Le mécanisme d'aller retour du cadre de transfert assure la progression séquentielle du circuit imprimé, de poste en poste. Aucun dommage ne peut se produire en fonctionnement à vide.

Si on veut arrêter le système, on peut adjoindre un détecteur de présence au poste 3, qui arrête l'alimentation électrique.

On peut noter aussi que le fonctionnement s'arrête, si un circuit imprimé vient à rester bloqué dans son outil.

**Revendications**

1. Dispositif pour le poinçonnage en grande série de plaques de circuit imprimé, caractérisé en ce qu'il comporte, en combinaison :
   - une matrice mince, propre à porter le circuit imprimé, et munie de perforations correspondant à celles désirées dans le circuit imprimé,
   - un porte-matrice comprenant au moins une grille de barreaux parallèles et parallélépipédiques, sensiblement équidistants, reliés à leurs deux extrémités opposées par deux barres perpendiculaires, en particulier logées dans la demi-hauteur des barreaux, et
   - des moyens de poinçonnage actionnables au droit de chacune des perforations de la matrice.

2. Dispositif selon la revendication 1, caractérisé en ce que les barreaux de la première grille comportent des évidements inclinés vers l'espace inter-barreaux, du côté de la matrice, là où celle-ci comporte des perforations au droit de ces barreaux, et en ce que cette première grille (4) de barreaux est à son tour supportée par une seconde grille (5) de barreaux (51, 52) parallèles et sensiblement équidistants, usinés en pointe du côté de la matrice, sauf là où ils supportent les premiers barreaux, par une section droite rectangulaire, tandis que ces seconds barreaux sont à leur tour supportés par une semelle rigide (6).

3. Dispositif selon la revendication 1, caractérisé en ce qu'il comporte un second poste dont la matrice est propre à recevoir le circuit imprimé en position conjuguée par rapport aux barreaux de la première grille, ce qui permet de réaliser ici les perforations situées au droit des barreaux, dans le premier poste.

4. Dispositif selon l'une des revendications 1 à 3, caractérisé en ce que les moyens de poinçonnage comportent des poinçons courts montés sur un porte-poinçons équipé d'un réducteur de course.

5. Dispositif selon la revendication 4, caractérisé en ce que la plaque supérieure du réducteur de course est équipée de brides alésées pour l'attelage oscillant des outils.

6. Dispositif selon l'une des revendications précédentes, caractérisé en ce que chaque poste est équipé de moyens de transfert permettant d'introduire et d'extraire la plaque de circuit imprimé, en même temps que d'évacuer les déchets de poinçonnage présents sous la matrice, en particulier par râclage.

7. Dispositif selon l'une des revendications précédentes, caractérisé en ce que l'épaisseur de la matrice (3) est de 5 à 10 millimètres, de préférence environ 6 millimètres.

8. Dispositif selon l'une des revendications précédentes, caractérisé en ce qu'il comporte un autre poste de poinçonnage pour la réalisation du contour de la plaque, des trous de forme de celle-ci, et de ses trous de diamètre important, en particulier supérieur à environ 2 millimètres.

9. Dispositif selon la revendication 8, caractérisé en ce que les différents postes, de mêmes dimensions, sont disposés côte à côte et desservis par des moyens de transfert actionnés par exemple par vérins pneumatiques.

10. Dispositif selon l'une des revendications précédentes, caractérisé en ce qu'il comporte en outre un poste de charge, propre à délivrer les plaques de circuits une à une, à partir d'une pile.

**Claims**

1. Device for the mass punching of printed circuit boards, characterised in that it comprises, in combination:
   - a thin die, suitable for holding the printed circuit, with perforations corresponding to those required in the printed circuit,
   - a die holder, comprising at least one grid of approximately equidistant, parallel and parallelepipedal bars, connected at their two opposite ends by two perpendicular cross bars, preferably lodged in half the height of the bars, and
   - punching means actuatable at right angles to each of the perforations of the die.

2. Device according to Claim 1, characterised in that the bars of the first grid comprise recesses, inclined towards the space between the bars, at the side facing the die, in regions where the latter comprises perforations at right angles to these bars; and in that this first grid (4) of bars is, in turn, supported by a second grid (5) of parallel and approximately equidistant bars (51, 52) tapered to a point at the side facing the die end, except in regions where they support the first set of bars, by a right angled rectangular section, whereas these second bars are, in turn, supported by a rigid plate (6).

3. Device according to Claim 1, characterised in that it comprises a second station, the die of which is capable of receiving the printed circuit in a position that is complementary with respect to the bars of the first grid, and which allows perforations to be produced here that would, in the first station, be situated at right angles to the bars.

4. Device according to one of the Claims 1 to 3, characterised in that the punching means comprise short punches mounted on a punch holder equipped with a stroke reducer.

5. Device according to Claim 4, characterised in that the upper plate of the stroke reducer is equipped with bored flanges for the oscillatory coupling of the tools.

6. Device according to one of the preceding Claims, characterised in that each station is equipped with conveyance means, allowing the printed circuit board to be inserted and extracted, with simultaneous clearing of the waste left by punching under the die, especially by scraping.

7. Device according to one of the preceding Claims, characterised in that the thickness of the die (3) is from 5 to 10 millimetres, preferably about 6 millimetres.

8. Device according to one of the preceding Claims, characterised in that it comprises another punching station for producing the contour of the plate, the shaped holes of the latter, and its holes of sizeable diameter, in particular more than about 2 millimetres.

9. Device according to Claim 8, characterised in that the different stations, of the same dimensions, are placed side by side and served by the conveyance means, actuated, for example, by pneumatic jacks.

10. Device according to one of the preceding Claims, characterised in that it comprises in addition a loading station capable of delivering the circuit boards one by one, from a stack.

**Patentansprüche**

1. Vorrichtung zum Stanzen gedruckter Leiterplatten in Großserie, dadurch gekennzeichnet, daß sie in Kombination folgendes aufweist:
   - eine dünne, zum Halten der gedruckten Leiterplatte geeignete Matrize, die mit Lochungen entsprechend den in der gedruckten Leiterplatte gewünschten Durchführungen versehen ist,
   - einen Matrizenträger, der mindestens ein Gitter mit parallelen und quaderförmigen Stangen aufweist, die im wesentlichen in gleichen Abständen angeordnet und an ihren beiden gegenüberliegenden Enden mittels zweier senkrechter Stangen miteinander verbunden sind, die insbesondere auf halber Höhe der Stangen liegen, und
   - Stanzeinrichtungen, die jeweils an der Stelle jeder Lochung in der Matrize betätigbar sind.

2. Vorrichtung nach Anspruch 1, dadurch gekennzeichnet, daß die Stangen des ersten Gitters zum Zwischenraum zwischen den Stangen auf der Matrizenseite hin geneigte Ausnehmungen dort aufweisen, wo die Matrize an der Stelle dieser Stangen Lochungen aufweist, und daß dieses erste Gitter (4) mit Stangen seinerseits durch ein zweites Gitter (5) mit Stangen (51, 52) abgestützt ist, welche parallel und im wesentlichen im gleichen Abstand voneinander verlaufen und matrizenseitig mit Ausnahme der Stellen, an denen sie die ersten Stangen abstützen, an der Spitze so bearbeitet sind, daß sie einen rechteckförmigen Querschnitt aufweisen, während sich diese zweiten Stangen ihrerseits auf einer starren Unterplatte (6) abstützen.

3. Vorrichtung nach Anspruch 1, dadurch gekennzeichnet, daß sie eine zweite Station aufweist, deren Matrize zur Aufnahme der gedruckten Leiterplatte in einer bezüglich der Stangen des ersten Gitters konjugierten Position geeignet ist, wodurch hier die an der Stelle der Stangen in der ersten Station gelegenen Durchführungen ausführbar sind.

4. Vorrichtung nach einem der Ansprüche 1 bis 3, dadurch gekennzeichnet, daß die Stanzvorrichtung kurze Lochstempel aufweist, welche auf einem mit einem Wegbegrenzungsschalter ausgerüsteten Lochstempelträger angebracht sind.

5. Vorrichtung nach Anspruch 4, dadurch gekennzeichnet, daß die Oberplatte des Wegbegrenzungsschalters mit Flanschen mit entsprechenden Ausbohrungen zur pendelnden Ankupplung von Werkzeugen versehen ist.

6. Vorrichtung nach einem der vorhergehenden Ansprüche, dadurch gekennzeichnet, daß jede Station eine Übertragungseinrichtung aufweist, mittels welcher die gedruckte Leiterplatte einsetzbar und herausnehmbar ist, während gleichzeitig die unter der Matrize vorhandenen Stanzabfälle insbesondere mittels eines Schabers entfernbar sind.

7. Vorrichtung nach einem der vorhergehenden Ansprüche, dadurch gekennzeichnet, daß die Matrize (3) eine Stärke von 5 bis 10 mm, vorzugsweise etwa 6 mm, aufweist.

8. Vorrichtung nach einem der vorhergehenden Ansprüche, dadurch gekennzeichnet, daß sie zur Bearbeitung des Außenumfangs der Platte, zur Ausbildung von Formbohrungen in derselben und von Durchführungen von erheblichem Durchmesser, insbesondere von mehr als etwa 2 mm, eine weitere Stanzstation aufweist.

9. Vorrichtung nach Anspruch 8, dadurch gekennzeichnet, daß die verschiedenen gleich großen Stationen nebeneinander angeordnet mittels Übertragungseinrichtungen steuerbar sind, die beispielsweise durch Pneumatikzylinder betätigt werden.

10. Vorrichtung nach einem der vorhergehenden Ansprüche, dadurch gekennzeichnet, daß sie außerdem eine Beschickungsstation aufweist, mittels welcher die Leiterplatten nacheinander von einem Stapel zuführbar sind.

FIG.1

# FIG. 2

## FIG. 3

## FIG. 4

## FIG. 8A

FIG.5

EP 0 278 870 B1

## FIG. 6B

## FIG. 6A

## FIG. 6C

149

147

145

143

141          141A

SE7

SE5

SE3

SE1

EP 0 278 870 B1

# FIG.7D

150

150A

148

146

144

142

# FIG.7C

SE 8

SE 6

SE 4

SE 2

EP 0 278 870 B1

FIG.8B

FIG.8C

FIG.9A

FIG.9B

FIG.9C

# FIG. 10

F2 →   ← F1

P16-3   P16-2   P16-1

V1

Q

P18-3   P18-2   P18-1

P25-3   P25-3   P25-2   P25-2   P25-1   P25-1

P3   P2   P1

↑ F4   ↓ F3

V2   V3

EP 0 278 870 B1

FIG. 11A

FIG. 11B

EP 0 278 870 B1

FIG.12A

# FIG. 12 B